# EUROPÄISCHE PATENTSCHRIFT

(11) **EP 1 186 039 B1**
(45) Veröffentlichungstag und Bekanntmachung des Hinweises auf die Patenterteilung: **08.11.2006**
(21) Anmeldenummer: 00934970.5
(22) Anmeldetag: 27.04.2000
(51) Int. Cl.: H01L 23/58, H01L 25/065, H01L 21/66

(54) **VERFAHREN UND VORRICHTUNG ZUR SICHERUNG EINES MEHRDIMENSIONAL AUFGEBAUTEN CHIPSTAPELS**
SECURITY METHOD AND DEVICE FOR A CHIP STACK WITH A MULTIDIMENSIONAL STRUCTURE
PROCEDE ET DISPOSITIF DE SECURITE D'UNE PILE DE PUCES MONTEE EN SAILLIE ET MULTIDIMENSIONNELLE

(30) Priorität: 03.05.1999 EP 99108768
(43) Veröffentlichungstag der Anmeldung: 13.03.2002
(73) Patentinhaber: Infineon Technologies AG, 81669 München (DE)
(72) Erfinder: KUX, Andreas, D-85540 Haar (DE); SMOLA, Michael, D-80636 München (DE)
(74) Vertreter: Epping - Hermann - Fischer
(86) Internationale Anmeldenummer: PCT/EP2000/003834
(87) Internationale Veröffentlichungsnummer: WO 2000/067319

(56) Entgegenhaltungen:
- EP-A- 0 221 351
- EP-A- 0 510 433
- WO-A-96/31101
- US-A- 5 229 647
- PATENT ABSTRACTS OF JAPAN vol. 011, no. 036 (E-477), 3. Februar 1987 (1987-02-03) & JP 61 203656 A (NEC CORP), 9. September 1986 (1986-09-09)

## Beschreibung

Die vorliegende Erfindung betrifft ein Verfahren und eine Vorrichtung zur Sicherung eines mehrdimensional aufgebauten Chipstapels, welcher eine Mehrzahl an jeweiligen Kontaktflächen miteinander verbundener Teilchips, von denen zumindest einer entsprechende Funktionskomponenten aufweist. , Ein Chipstapel für ein Speichermodul ist aus US-A-5 229 647 bekannt.

Unter Funktionskomponenten sind dabei in die Teilchips integrierte mikroelektronische Schaltungen oder mikromechanische Komponenten jeglicher Art zu verstehen. Als Chip kann z.B. ein Wafer oder ein Teil eines Wafers aus einem Halbleitermaterial oder einem sonstigen geeigneten Material verstanden werden.

Die der vorliegenden Erfindung zugrundeliegende Problematik besteht allgemein darin, bei solch einem Chipstapel sicherzustellen, daß die Verbindung zwischen den einzelnen Teilchips an den jeweiligen Kontaktflächen nicht gelöst werden kann, ohne daß eine solche Beschädigung von einer entsprechenden Funktionskomponente feststellbar ist. Läßt sich eine solche Beschädigung nämlich feststellen, können entsprechende Gegenmaßnahmen getroffen werden, die beispielsweise ein weiteres Betreiben einer oder mehrerer Funktionskomponenten verhindern.

Bisher wurden in dieser Richtung wenig Überlegungen zur Sicherung eines mehrdimensional aufgebauten Chipstapels angestrengt, da dreidimensionale Chipverbindungen noch keine nennenswerte Verbreitung aufweisen. Aus EP-A-0 510 433 ist eine Vorrichtung bekannt, bei der Schaltkreise eines Chipstapels gesichert werden können.

Daher ist es Aufgabe der vorliegenden Erfindung, ein Verfahren und eine Vorrichtung zur Sicherung eines mehrdimensional aufgebauten Chipstapels der eingangs genannten Art zu schaffen, welche physikalische Angriffe auf sicherheitskritische Chips, wie z.B. Chipkarten bzw. Codekarten, erkennbar machen können. Insbesondere das Auftrennen des Chipstapels, um auf Teile des Chips zuzugreifen, soll detektierbar sein.

Erfindungsgemäß wird diese Aufgabe durch das in Anspruch 1 angegebene Verfahren bzw. die in Anspruch 5 angegebene Vorrichtung gelöst.

Die der vorliegenden Erfindung zugrundeliegende Idee besteht darin, daß ein multidimensionaler Leitungsmäander im Chipverbund integriert wird, durch den ständig oder in bestimmten Zeitabständen elektrische Signale von einem ersten Punkt zu einem zweiten Punkt gesendet werden. Im einfachsten Fall läßt sich, wenn die Signale am zweiten Punkt ankommen bzw. unverändert ankommen, daraus auf die Unversehrtheit des dazwischenliegenden Signalwegs schließen. In bezug auf den jeweiligen Teilchip vertikale Durchkontaktierungen werden dazu verwendet, planare Leiterbahnmuster verschiedener Teilchips zu verbinden und so einen durch alle aufeinandermontierten Teilchips laufenden Signalweg zu schaffen.

Dies hat den Vorteil, daß die Integration der erfindungsgemäßen Sicherungsvorrichtung im Rahmen üblicher Prozeßschritte, insbesondere Metallisierung und Durchkontaktierung, stattfinden kann.

In den Unteransprüchen finden sich vorteilhafte Weiterbildungen und Verbesserungen des in Anspruch 1 angegebenen Verfahrens bzw. der in Anspruch 6 angegebenen Vorrichtung.

Gemäß einer bevorzugten Weiterbildung werden ein oder mehrere Funktionskomponenten deaktiviert, falls eine Beschädigung des Chipstapels festgestellt wird. Somit kann verhindert werden, daß geheimzuhaltende Informationen von Unbefugten ausgespäht werden.

Gemäß einer weiteren bevorzugten Weiterbildung wird ein von der Sendeeinrichtung zur Empfangseinrichtung verlaufender durchgehender elektrischer Referenzsignalweg gebildet und darüber gleichzeitig mit dem Senden des elektrischen Signals ein elektisches Referenzsignal gesendet. Dies stellt sicher, daß dem Empfänger kein künstlicher Sender anstelle des echten Senders vorgetäuscht werden kann.

Gemäß einer weiteren bevorzugten Weiterbildung werden die Sendeeinrichtung und die Empfangseinrichtung in verschiedenen Teilchips vorgesehen. Damit können Sender und Empfänger nicht über eine Brücke im gleichen Teilchip kurzgeschlossen werden.

Gemäß einer weiteren bevorzugten Weiterbildung werden mehrere Paare von Sendeeinrichtung und Empfangseinrichtung in verschiedenen Teilchips vorgesehen. Somit können sich die Teilchips wechselweise überprüfen.

Gemäß einer weiteren bevorzugten Weiterbildung sind die jeweiligen Leiterbahnen in den Teilchips planar ausgebildet. So lassen sich ohnehin vorhandene Metallisierungsschichten für die Sicherungsvorrichtung verwenden.

Gemäß einer weiteren bevorzugten Weiterbildung sind Leiterbahnen zwischen den Teilchips in einer Metallisierungsschicht zur Verbindung jeweils zweier Teilchips ausgebildet. Somit erfüllt die Metallschicht zur vertikalen Verbindung, z.B. Lotverbindung, eine Doppelfunktion.

Gemäß einer weiteren bevorzugten Weiterbildung ist insbesondere für den Fall über strukturiertes Lotmetall verbunden sind, eine Metallisierungsschicht ohne Verbindungsfunktion einseitig als Abschirmung auf einem außen liegenden Teilchip vorgesehen.

Gemäß einer weiteren bevorzugten Weiterbildung ist der Signalweg vertikal durch die Teilchips laufend mäanderförmig ausgebildet. Im einfachsten Fall ist der Mäander in einer vertikalen Ebene ausgebildet. Es sind aber auch kompliziertere Raumformen entsprechend der jeweiligen Chipaufteilung vorstellbar.

Gemäß einer weiteren bevorzugten Weiterbildung sind Leiterbahnen in einem oder mehreren Teilchips, insbesondere an den Stirnflächen des Chipstapels, planar mäanderförmig ausgebildet. Damit lassen sich engmaschige Abschirmungen an größeren freien Flächenbereichen erzielen.

Ausführungsbeispiele der Erfindung sind in den Zeichnungen dargestellt und in der nachfolgenden Beschreibung näher erläutert.

Es zeigen:
- Fig. 1: eine schematische Darstellung eines aus drei Teilchips aufgebauten Chipstapels mit einer Sicherungseinrichtung gemäß einem ersten Ausführungsbeispiel der vorliegenden Erfindung;
- Fig. 2: eine schematische Darstellung eines aus drei Teilchips aufgebauten Chipstapels mit einer Sicherungseinrichtung gemäß einem zweiten Ausführungsbeispiel der vorliegenden Erfindung;
- Fig. 3: eine schematische Darstellung eines aus drei Teilchips aufgebauten Chipstapels mit einer Sicherungseinrichtung gemäß einem dritten Ausführungsbeispiel der vorliegenden Erfindung;
- Fig. 4: eine schematische Darstellung eines aus drei Teilchips aufgebauten Chipstapels mit einer Sicherungseinrichtung gemäß einem vierten Ausführungsbeispiel der vorliegenden Erfindung;
- Fig. 5: eine schematische Darstellung eines aus drei Teilchips aufgebauten Chipstapels mit einer Sicherungseinrichtung gemäß einem fünften Ausführungsbeispiel der vorliegenden Erfindung; und
- Fig. 6: eine schematische Darstellung eines aus drei Teilchips aufgebauten Chipstapels mit einer Sicherungseinrichtung gemäß einem sechsten Ausführungsbeispiel der vorliegenden Erfindung.

In den Figuren bezeichnen gleiche Bezugszeichen gleiche oder funktionsgleiche Elemente.

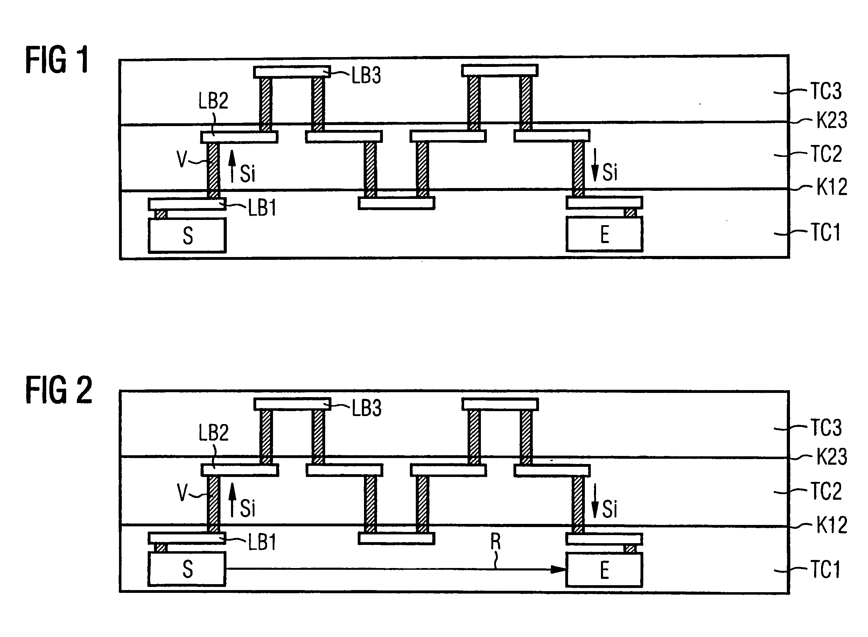

Fig. 1 ist eine schematische Darstellung eines aus drei Teilchips aufgebauten Chipstapels mit einer Sicherungseinrichtung gemäß einem ersten Ausführungsbeispiel der vorliegenden Erfindung.

In Figur 1 bezeichnen TC1, TC2, TC3 einen ersten, zweiten, bzw. dritten Teilchip, welche in Form eines Stapels miteinander an jeweiligen Kontaktflächen K12, K23 verbunden sind, z.B. verlötet sind. Die jeweiligen Teilchips enthalten sicherheitssensitive Funktionskomponenten, welche aus Gründen der Vereinfachung in den Figuren nicht dargestellt sind.

LB1, LB2 und LB3 bezeichnen in den entsprechenden Teilchips TC1, TC2, TC3 vorgesehene Leiterbahnen, welche in bekannter Planartechnologie erstellt sind und im gezeigten Beispiel unter der jeweiligen Oberfläche des betreffenden Teilchips vergraben sind (beispielsweise unter einer Isolationsschicht).

Zur Verbindung der Leiterbahnen sind Durchkontaktierungen V (Vias mit leitender Füllung) durch die Teilchips TC1, TC2, TC3 vorgesehen, welche dafür sorgen, daß ein durch alle Teilchips verlaufender durchgehender elektrischer Signalweg gebildet wird. An einem ersten Ende des elektrischen Signalwegs vorgesehen ist eine Sendeeinrichtung S, und an einem zweiten Ende des elektrischen Signalwegs vorgesehen ist eine Empfangseinrichtung E.

Zur Sicherung des derart aufgebauten mehrdimensionalen Typstapels wird nun im Betrieb ein elektrisches Signal unter regelmäßigen Abständen, z.B. im Sekundentakt, von der Sendeeinrichtung S zu der Empfangseinrichtung E geleitet. Die Empfangseinrichtung enthält eine nicht dargestellt intelligente Schaltung, welche eine Beschädigung des Chipstapels feststellt, wenn das elektrische Signal SI in der Empfangseinrichtung E nicht empfangbar ist. Diese Festellungseinrichtung sorgt weiterhin dafür, daß bei Festellung einer Beschädigung des Chipstapels sicherheitsrelevante Funktionskomponenten in den Teilchips TC1, TC2, TC3 deaktiviert werden, falls eine Beschädigung des Chipstapels festgestellt wird. Beispielsweise kann eine solche Deaktivierung ein Löschen von Speicherinhalten von Speicherkomponenten sein.

Die Art des elektrischen Signals ist im wesentlichen beliebig. Es muß nur ein Muster sein, dessen Struktur der Empfänger kennt.

Der in Figur 1 gezeigte durchgehende Signalweg hat die Form eines in einer vertikalen Ebene liegenden Mäanders. Um die Sicherung gegebenenfalls in die dritte Dimension auszudehnen, können entweder mehrere solcher Sicherungsvorrichtungen nebeneinander verwendet werden oder können die Leiterbahnen im jeweiligen Teilchip in die dritte Dimension (Tiefe) verlaufend ausgebildet sein.

Fig. 2 ist eine schematische Darstellung eines aus drei Teilchips aufgebauten Chipstapels mit einer Sicherungseinrichtung gemäß einem zweiten Ausführungsbeispiel der vorliegenden Erfindung.

Bei der in Figur 2 gezeigten zweiten Ausführungsform ist zusätzlich ein von der Sendeeinrichtung S zu der Empfangseinrichtung E verlaufender durchgehender elektrischer Referenzsignalweg gebildet, über den gleichzeitig mit dem Senden des elektrischen Signals SI ein elektrisches Referenzsignal R gesendet wird. Somit ist das Kriterium für die Unversehrtheit des Chipstapels nicht nur die reine Empfangbarkeit des Signals SI am Empfänger, sondern auch die gleichzeitige Empfangbarkeit des Referenzsignals R. Damit läßt sich sicherstellen, daß der Empfangseinrichtung E keine künstliche Sendeeinrichtung anstatt der echten Sendeeinrichtung S vorgetäuscht wird.

Es sei erwähnt, daß der Referenzsignalweg analog wie der erste Signalweg mit Leiterbahnen und Durchkontaktierungen aufgebaut werden kann und nur aus Gründen der Vereinfachung hier nur als schematische Linie dargestellt ist.

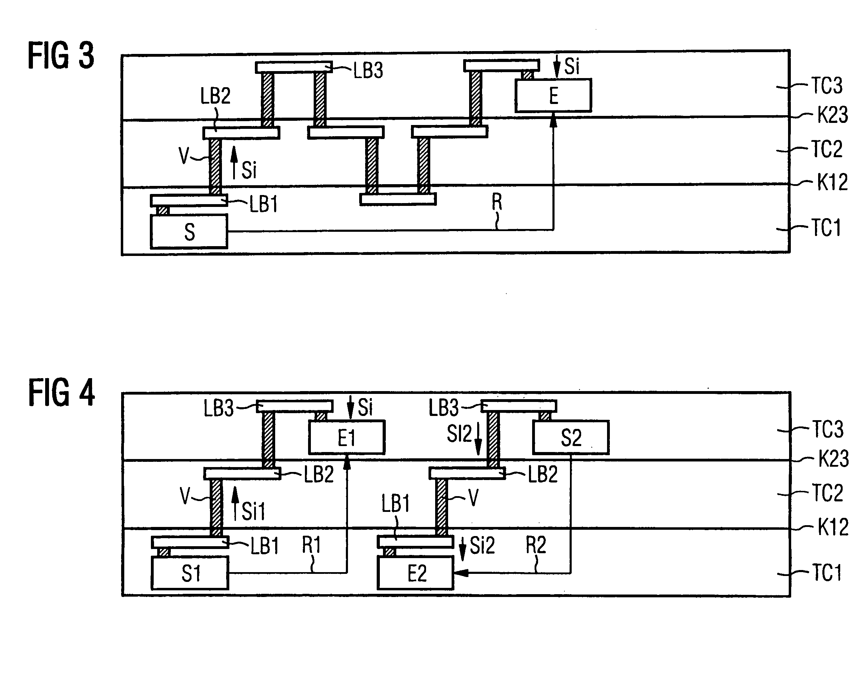

Fig. 3 ist eine schematische Darstellung eines aus drei Teilchips aufgebauten Chipstapels mit einer Sicherungseinrichtung gemäß einem dritten Ausführungsbeispiel der vorliegenden Erfindung.

Bei der in Figur 3 dargestellten dritten Ausführungsform sind die Sendeeinrichtung S und die Empfangseinrichtung E in verschiedenen Teilchips TC1 bzw. TC3 untergebracht. Damit läßt sich verhindern, daß sie über eine Brücke zwischen Durchkontaktierungen des Teilchips TC1 kurzgeschlossen werden.

Fig. 4 ist eine schematische Darstellung eines aus drei Teilchips aufgebauten Chipstapels mit einer Sicherungseinrichtung gemäß einem vierten Ausführungsbeispiel der vorliegenden Erfindung.

Bei der in Figur 4 gezeigten vierten Ausführungsform sind zwei Signalwege mit einer jeweiligen Sendeeinrichtung S1, S2, und einer jeweiligen Empfangseinrichtung E1, E2 vorgesehen. Hierbei überprüfen sich die Teilchips wechselweise durch Senden der Signale SI1, R1 bzw. SI2, R2 in entgegengesetzten Richtungen. Dies erhöht die Wirksamkeit der Sicherungsvorrichtung.

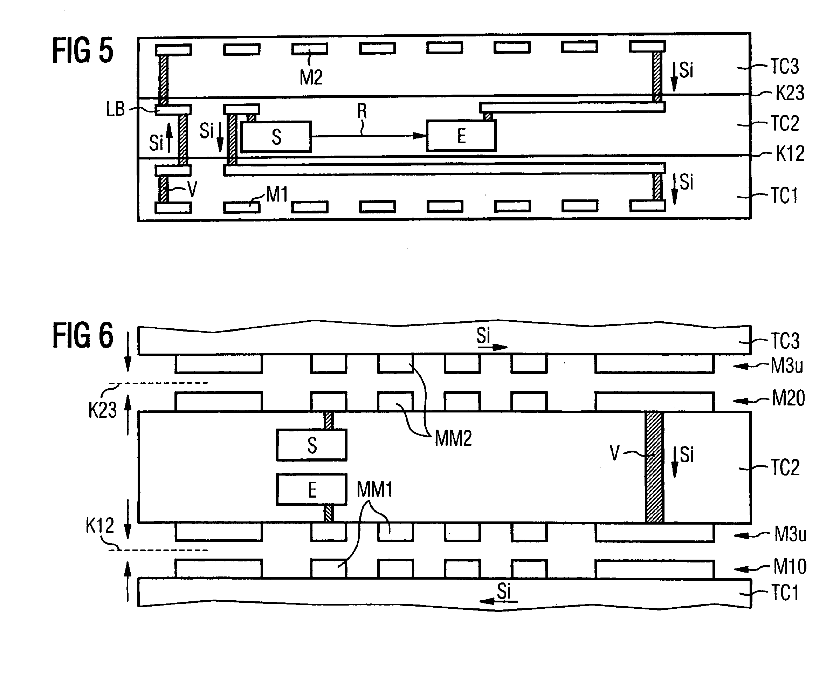

Fig. 5 ist eine schematische Darstellung eines aus drei Teilchips aufgebauten Chipstapels mit einer Sicherungseinrichtung gemäß einem fünften Ausführungsbeispiel der vorliegenden Erfindung.

Bei der in Figur 5 gezeigten Ausführungsform sind die Sendeeinrichtung S und die Empfangseinrichtung E im mittleren Teilchip TC2 untergebracht. Im Gegensatz zu oben beschriebener Ausführungsform sind bei dieser Ausführungsform zweidimensionale Mäander-Leiterbahnenmuster M1, M2 in den Signalweg mit einbezogen. Diese Mäander-Leiterbahnenmuster sind an der oberen bzw. unteren Stirnfläche des Chipstapels vorgesehen und dienen zum Schutz dieser beiden großen freiliegenden Stirnflächen. Ansonsten ist die Funktione der Sicherungsvorrichtung nach diesem fünften Ausführungsbeispiel gleich wie diejenige der bereits oben beschriebenen Ausführungsbeispiele.

Fig. 6 ist eine schematische Darstellung eines aus drei Teilchips aufgebauten Chipstapels mit einer Sicherungseinrichtung gemäß einem sechsten Ausführungsbeispiel der vorliegenden Erfindung.

Bei der in Figur 6 gezeigten Ausführungsform sind die drei Teilchips TC1, TC2, TC3 im noch nicht miteinander verbundenen Zustand dargestellt, wobei die späteren Kontaktflächen K12, K23 schematisch durch eine gestrichelte Linie und entsprechende Pfeile zusammenfügend dargestellt sind.

In Figur 6 bezeichnen M10 eine obere Metallisierung des ersten Teilchips TC1, M2U eine unter Metallisierung des zweiten TC2, M2O eine obere Metallisierung des zweiten Teilchips TC2, und M3U eine untere Metallisierung des dritten Teilchips TC3. Die jeweiligen an den Kontaktflächen K12 und K23 gegenüberliegenden Metallisierungen weisen die gleiche Struktur auf, wobei in der Mitte eine jeweilige mäanderförmige Struktur MM1 bzw. MM2 vorgesehen ist. Die in Figur 6 gezeigte sechste Ausführungsform nutzt die Tatsache aus, daß bei vertikalen Chipverbindungsverfahren zwischen dem oberen und unteren Teilchip eine leitfähige Schicht entsteht, sofern an den entsprechnenden Stellen Verbindungsmetall, wie z.B. Lot, stehen bleibt, und nicht durch eine Strukturierung mit nachfolgendem Ätzschritt entfernt wird.

Bei dieser Ausführungsform wird die zur Verbindung zwischen den Teilchips verwendete Metallschicht dazu verwendet, ein jeweiliges mäanderförmiges Leiterbahnmuster MM1 bzw. MM2 auszubilden, da es Teil des Signalwegs ist, welcher durch sämtliche Teilchips TC1, TC2, TC3 verläuft. Somit ist in den Bereichen, die nicht unmittelbar zur vertikalen Kontaktierung verwendet werden eine strukturierte Abschirmung zwischen den Teilchips ausgebildet. Sie schützt zusätzlich zu den Elementen der darüberliegenden aktiven Schicht die darunterliegende Schaltungsteile. Ihre Freiheit ist in gewisser Weise durch die notwendige Justage der Teilchips zueinander begrenzt. Dafür entsteht sie sofern man nicht die vertikale Durchkontaktierung extrem dicht ist, ohne Zusatzaufwand bei der vertikalen Integration.

Insbesondere kann ein Lotmetall noch einseitig auf die Unterseite des untersten Chips aufgebracht werden und die Schaltung so allseitig geschützt werden.

Bei der gezeigten sechsten Ausführungsform sind die Sendeeinrichtung S und die Empfangseinrichtung E im mittleren Teilchip untergebracht. Der Signalweg verläuft von der Sendeeinrichtung S nach oben in die mäanderförmige Leiterbahnschicht MM2, von dort über die Durchkontaktierung V in die mäanderförmige Leiterbahnschicht MM1 und von dort senkrecht nach oben zur Empfangseinrichtung E.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Insbesondere ist die vorliegende Erfindung nicht auf drei miteinander verbundene Teilchips beschränkt, sondern kann auf eine beliebige Kombination von Teilchips angewendet werden. Auch ist die flächen- oder raummäßige Gestaltung des durchgehenden Signalwegs entsprechend der geometrischen Verhältnisse der Einzelchips beliebig aufteilbar.

Die Sendeeinrichtung und die Empfangseinrichtung können sich in einem der Teilchips befinden, können aber ebenfalls außerhalb der Chips vorgesehen sein, beispielsweise in einer Fassung oder Einspannung des Chips.

Für den Fall, daß sich z.B. aus technischen Gründen am Chip keine rückseitige Abschirmung anbringen läßt, kann ein Extra-Chip nur mit Abschirmung, aber ohne Funktionskomponenten angefügt werden.

## Patentansprüche

1. Verfahren zur Sicherung eines mehrdimensional aufgebauten Chipstapels, welcher eine Mehrzahl an jeweiligen Kontaktflächen (K12, K23) miteinander verbundener Teilchips (TC1, TC2, TC3), von denen zumindest einer entsprechende Funktionskomponenten enthält, aufweist, mit den Schritten:
Vorsehen von jeweiligen Leiterbahnen (LB1, LB2, LB3) in den Teilchips (TC1, TC2, TC3);
Vorsehen von Durchkontaktierungen (V) an den jeweiligen Kontaktflächen (K12, K23), welche jeweils Leiterbahnen verschiedener Teilchips (TC1, TC2, TC3) miteinander verbinden, so daß ein durch die Teilchips (TC1, TC2, TC3) verlaufender durchgehender elektrischer Signalweg gebildet wird;
Senden eines elektrischen Signals (SI; SI1, SI2) von einer an einem ersten Ende des elektrischen Signalwegs vorgesehenen Sendeeinrichtung (S; S1, S2) zu einer an einem zweiten Ende des elektrischen Signalwegs vorgesehenen Empfangseinrichtung (E; E1, E2);
Vorsehen eines zusätzlichen von der Sendeeinrichtung (S; S1, S2) zur Empfangseinrichtung (E; E1, E2) verlaufenden durchgehenden elektrischen Referenzsignalweges, wobei über diesen gleichzeitig mit dem Senden des elektrischen Signals (SI; SI1, SI2) ein elektrisches Referenzsignal (R; R1, R2) gesendet wird; und
Feststellen der Beschädigung des Chipstapels, wenn das elektrische Signal (SI; SI1, SI2) nicht empfangbar ist.

2. Verfahren nach Anspruch 1, **dadurch gekennzeichnet, daß** ein oder mehrere Funktionskomponenten deaktiviert werden, falls eine Beschädigung des Chipstapels festgestellt wird.

3. Verfahren nach Anspruch 1 oder 2, **dadurch gekennzeichnet, daß** die Sendeeinrichtung (S; S1, S2) und die Empfangseinrichtung (E; E1, E2) in verschiedenen Teilchips vorgesehen werden.

4. Verfahren nach einem der vorhergehenden Ansprüche, **dadurch gekennzeichnet, daß** mehrere Paare von Sendeeinrichtung (S; S1, S2) und Empfangseinrichtung (E; E1, E2) in verschiedenen Teilchips vorgesehen werden.

5. Vorrichtung zur Sicherung eines mehrdimensional aufgebauten Chipstapels, welcher eine Mehrzahl an jeweiligen Kontaktflächen (K12, K23) miteinander verbundener Teilchips (TC1, TC2, TC3) mit entsprechenden Funktionskomponenten aufweist, mit:
jeweiligen Leiterbahnen (LB1, LB2, LB3) in den Teilchips (TC1, TC2, TC3);
Durchkontaktierungen (V) an den jeweiligen Kontaktflächen (K12, K23), welche jeweils Leiterbahnen verschiedener Teilchips (TC1, TC2, TC3) miteinander verbinden, so daß ein durch die Teilchips (TC1, TC2, TC3) verlaufender durchgehender elektrischer Signalweg gebildet ist;
**gekennzeichnet durch**
eine an einem ersten Ende des elektrischen Signalwegs vorgesehenen Sendeeinrichtung (S; S1, S2) und eine an einem zweiten Ende des elektrischen Signalwegs vorgesehenen Empfangseinrichtung (E; E1, E2), wobei zusätzlich ein von der Sendeeinrichtung (S; S1, S2) zur Empfangseinrichtung (E; E1, E2) verlaufender durchgehender elektrischer Referenzsignalweg gebildet ist; und
eine Feststellungseinrichtung zum Feststellen der Beschädigung des Chipstapels, wenn das elektrische Signal (SI; SI1, SI2) nicht empfangbar ist.

6. Vorrichtung nach Anspruch 5, **dadurch gekennzeichnet, daß** eine Deaktivierungseinrichtung zum Deaktivieren einer oder mehrerer Funktionskomponenten, falls die Feststellungseinrichtung eine Beschädigung des Chipstapels festgestellt, vorgesehen ist.

7. Vorrichtung nach Anspruch 5 oder 6, **dadurch gekennzeichnet, daß** die Sendeeinrichtung (S; S1, S2) und die Empfangseinrichtung (E; E1, E2) in verschiedenen Teilchips vorgesehen sind.

8. Vorrichtung nach einem der Ansprüche 5 bis 7, **dadurch gekennzeichnet, daß** mehrere Paare von Sendeeinrichtung (S; S1, S2) und Empfangseinrichtung (E; E1, E2) in verschiedenen Teilchips vorgesehen sind.

9. Vorrichtung nach einem der Ansprüche 5 bis 8, **dadurch gekennzeichnet, daß** die jeweiligen Leiterbahnen (LB1, LB2, LB3) in den Teilchips (TC1, TC2, TC3) planar ausgebildet sind.

10. Vorrichtung nach Anspruch 9, **dadurch gekennzeichnet, daß** Leiterbahnen (MM1, MM2) zwischen den Teilchips in einer Metallisierungsschicht zur Verbindung jeweils zweier Teilchips ausgebildet sind.

11. Vorrichtung nach Anspruch 10, **dadurch gekennzeichnet, daß** eine Metallisierungsschicht ohne Verbindungsfunktion einseitig als Abschirmung auf einem außen liegenden Teilchip vorgesehen ist.

12. Vorrichtung nach einem der Ansprüche 5 bis 11, **dadurch gekennzeichnet, daß** der Signalweg vertikal durch die Teilchips (TC1, TC2, TC3) laufend mäanderförmig ausgebildet ist.

13. Vorrichtung nach einem der Ansprüche 5 bis 12, **dadurch gekennzeichnet, daß** Leiterbahnen (M1, M2; MM1, MM2) in einem oder mehreren Teilchips, insbesondere an den Stirnflächen des Chipstapels, planar mäanderförmig ausgebildet sind.

## Claims

1. Method of securing a multi-dimensionally constructed chip stack, which contains a multiplicity of part chips (TC1, TC2, TC3) connected to one another at respective contact areas. (K12, K23), of which part chips at least one contains appropriate functional components, having the steps:
providing respective conductor tracks (LB1, LB2, LB3) in the part chips (TC1, TC2, TC3);
providing plated-through holes (V) at the respective contact areas (K12, K23), which in each case interconnect conductor tracks of various part chips (TC1, TC2, TC3), so that a continuous electrical signal path running through the part chips (TC1, TC2, TC3) is formed;
transmitting an electrical signal (SI; SI1, SI2) from a transmitting device (S; S1, S2) provided at a first end of the electrical signal path to a receiving device (E; E1, E2) provided at a second end of the electrical signal path;
providing an additional continuous electrical reference signal path running from the transmitting device (S; S1; S2) to the receiving device (E; E1, E2), an electrical reference signal (R; R1, R2) being transmitted over said path at the same time as the electrical signal (SI; SI1, SI2) is transmitted; and
determining that there is damage to the chip stack when the electrical signal (SI; SI1, SI2) cannot be received.

2. The method as claimed in claim 1, **characterized in that** one or more functional components are deactivated if it is determined that there is damage to chip stack.

3. The method as claimed in claim 1 or 2, **characterized in that** the transmitting device (S; S1, S2) and the receiving device (E; E1, E2) are provided in different part chips.

4. The method as claimed in one of the preceding claims, **characterized in that** a plurality of pairs of transmitting device (S; S1, S2) and receiving device (E; E1, E2) are provided in different part chips.

5. Device for securing a multi-dimensionally constructed chip stack, which has a multiplicity of part chips (TC1, TC2, TC3) interconnected at respective contact areas (K12, K23) and having appropriate functional components, having:
respective conductor tracks (LB1, LB2, LB3) in the part chips (TC1, TC2, TC3);
plated-through holes (V) at the respective contact areas (K12, K23), which in each case interconnect conductor tracks of different part chips (TC1, TC2, TC3), so that a continuous electrical signal path running through the part chips (TC1, TC2, TC3) is formed;
**characterized by**
a transmitting device (S; S1, S2) provided at a first end of the electrical signal path and a receiving device (E; E1, E2) provided at a second end of the electrical signal path a continuous electrical reference signal path running from the transmitting device (S; S1; S2) to the receiving device (E; E1; E2) being formed in addition; and
a determining device for determining that there is damage to the chip stack if the electrical signal (SI; SI1, SI2) cannot be received.

6. The device according to claim 5, **characterized in that** a deactivation device is provided to deactivate one or more functional components if the determining device determines that there is damage to the chip stack.

7. The device according to one of the claims 5 or 6, **characterized in that** the transmitting device (S; S1, S2) and the receiving device (E; E1, E2) are provided in different part chips.

8. The device according to one of claims 5 or 7, **characterized in that** a plurality of pairs of transmitting device (S; S1, S2) and receiving device (E; E1, E2) are provided in different part chips.

9. The device according to one of claims 5 to 8, **characterized in that** the respective conductor tracks (LB1, LB2, LB3) in the part chips (TC1, TC2, TC3) are of planar design.

10. The device according to claim 9, **characterized in that** conductor tracks (MM1, MM2) are formed between the part chips in a metallization layer for connecting to part chips in each case.

11. The device according to claim 10, **characterized in that** a metallization layer without a connecting function is provided on one side as shielding on a part chip located on the outside.

12. The device according to one of claims 5 to 11, **characterized in that** the signal path is designed to run in a meandering way vertically through the part chips (TC1, TC2, TC3).

13. The device according to one of claims 5 to 12, **characterized in that** conductor tracks (M1, M2; MM1, MM2) are formed in a planar meandering way in one or more part chips, in particular at the end faces of the chip stack.

## Revendications

1. Procédé pour la sécurisation d'une pile de puces à structure multidimensionnelle comportant plusieurs puces partielles (TC1, TC2, TC3) qui sont assemblées par des surfaces de contact respectives (K12, K23) et parmi lesquelles au moins l'une contient des composants fonctionnels correspondants, avec les étapes suivantes :
on prévoit des pistes conductrices respectives (LB1, LB2, LB3) dans les puces partielles (TC1, TC2, TC3) ;
on prévoit sur les surfaces de contact respectives (K12, K23) des connexions par trous traversants (V) qui relient entre elles à chaque fois des pistes conductrices de différentes puces partielles (TC1, TC2, TC3) de manière à former un trajet de signal électrique continu s'étendant à travers les puces partielles (TC1, TC2, TC3) ;
on émet un signal électrique (SI ; SI1, SI2) à partir d'un dispositif d'émission (S ; S1, S2) prévu à une première extrémité du trajet de signal électrique vers un dispositif de réception (E ; E1, E2) prévu à une deuxième extrémité du trajet de signal électrique ;
on prévoit un trajet de signal de référence électrique supplémentaire continu s'étendant du dispositif d'émission (S ; S1, S2) au dispositif de réception (E ; E1, E2), un signal de référence électrique (R ; R1, R2) étant émis par l'intermédiaire de ce trajet en même temps que le signal électrique (SI ; SI1, SI2) ; et
on constate la détérioration de la pile de puces lorsque le signal électrique (SI ; SI1, SI2) ne peut pas être reçu.

2. Procédé selon la revendication 1, **caractérisé par le fait que** l'on désactive un ou plusieurs composants fonctionnels si une détérioration de la pile de puces est constatée.

3. Procédé selon la revendication 1 ou 2, **caractérisé par le fait que** le dispositif d'émission (S ; S1, S2) et le dispositif de réception (E ; E1, E2) sont prévus dans des puces partielles différentes.

4. Procédé selon l'une des revendications précédentes, **caractérisé par le fait que** plusieurs paires de dispositifs d'émission (S ; S1, S2) et de dispositifs de réception (E ; E1, E2) sont prévues dans des puces partielles différentes.

5. Dispositif pour la sécurisation d'une pile de puces à structure multidimensionnelle comportant plusieurs puces partielles (TC1, TC2, TC3) qui sont assemblées par des surfaces de contact respectives (K12, K23) et qui contiennent des composants fonctionnels correspondants, avec :
des pistes conductrices respectives (LB1, LB2, LB3) dans les puces partielles (TC1, TC2, TC3) ;
sur les surfaces de contact respectives (K12, K23), des connexions par trous traversants (V) qui relient entre elles à chaque fois des pistes conductrices de différentes puces partielles (TC1, TC2, TC3) de manière à former un trajet de signal électrique continu s'étendant à travers les puces partielles (TC1, TC2, TC3) ;
**caractérisé par** :
un dispositif d'émission (S ; S1, S2) prévu à une première extrémité du trajet de signal électrique et un dispositif de réception (E ; E1, E2) prévu à une deuxième extrémité du trajet de signal électrique, un trajet de signal de référence électrique continu s'étendant en plus du dispositif d'émission (S ; S1, S2) au dispositif de réception (E ; E1, E2) ; et
un dispositif de constatation pour constater la détérioration de la pile de puces lorsque le signal électrique (SI ; SI1, SI2) ne peut pas être reçu.

6. Dispositif selon la revendication 5, **caractérisé par le fait qu'**un dispositif de désactivation est prévu pour désactiver un ou plusieurs composants fonctionnels si le dispositif de constatation constate une détérioration de la pile de puces.

7. Dispositif selon la revendication 5 ou 6, **caractérisé par le fait que** le dispositif d'émission (S ; S1, S2) et le dispositif de réception (E ; E1, E2) sont prévus dans des puces partielles différentes.

8. Dispositif selon l'une des revendications 5 à 7, **caractérisé par le fait que** plusieurs paires de dispositifs d'émission (S ; S1, S2) et de dispositifs de réception (E ; E1, E2) sont prévues dans des puces partielles différentes.

9. Dispositif selon l'une des revendications 5 à 8, **caractérisé par le fait que** les pistes conductrices respectives (LB1, LB2, LB3) sont conçues planaires dans les puces partielles (TC1, TC2, TC3).

10. Dispositif selon la revendication 9, **caractérisé par le fait que** des pistes conductrices (MM1, MM2) sont conçues entre les puces partielles dans une couche de métallisation pour l'assemblage à chaque fois de deux puces partielles.

11. Dispositif selon la revendication 10, **caractérisé par le fait qu'**une couche de métallisation sans fonction d'assemblage est prévue d'un côté comme blindage sur une puce partielle se trouvant au bord vers l'extérieur.

12. Dispositif selon l'une des revendications 5 à 11, **caractérisé par le fait que** le trajet de signal est conçu en forme de méandre s'étendant verticalement à travers les puces partielles (TC1, TC2, TC3).

13. Dispositif selon l'une des revendications 5 à 12, **caractérisé par le fait que** des pistes conductrices (M1, M2 ; MM1, MM2) sont conçues en forme de méandres et planaires dans une ou plusieurs puces partielles, notamment sur les surfaces de contact de la pile de puces.
